(19) Europäisches Patentamt
European Patent Office
Office européen des brevets

(11) Publication number: 0 397 185
A1

(12) # EUROPEAN PATENT APPLICATION

(21) Application number: 90108873.2

(22) Date of filing: 11.05.90

(51) Int. Cl.5: B32B 1/02, B32B 27/00, B32B 27/18, B65D 90/46, C08K 5/19, C08K 5/17, C09K 3/16

(30) Priority: 12.05.89 US 351239

(43) Date of publication of application: 14.11.90 Bulletin 90/46

(84) Designated Contracting States: AT BE CH DE DK ES FR GB GR IT LI LU NL SE

(71) Applicant: W.R. Grace & Co.-Conn.
1114 Avenue of the Americas
New York New York 10036(US)

(72) Inventor: Havens, Marvin, R.
206 Hackney Road
Greer, South Carolina 29650(US)

(74) Representative: Abitz, Walter, Dr.-Ing. et al
Abitz, Morf, Gritschneder, Freiherr von Wittgenstein Postfach 86 01 09
D-8000 München 86(DE)

(54) **Permanently antistatic polymeric rigid containers.**

(57) Disclosed are antistatic rigid laminate containers (2) of thermoplastic material adapted for holding electronic devices that are sensitive to static electricity. The containers comprise a rigid dielectric sheet (14) having adhered thereto a flexible antistatic film (16, 16A). The film preferably comprises acid copolymer and quaternary amine.

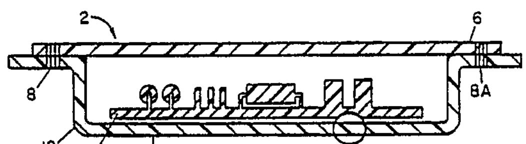


FIG. 1

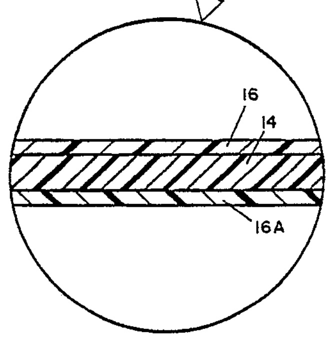


FIG. 2

EP 0 397 185 A1

## Permanently Antistatic Polymeric Rigid Containers

This invention relates to rigid containers of thermoplastic material adapted for holding electronic devices that are sensitive to static electricity. Typically thermoplastics are insulators and hold a charge. But the present containers protect the electronic devices from being ruined by static electricity as the containers are antistatic, and thus dissipate the static charge. The container comprises a thermoplastic rigid sheet that has adhered to it a flexible thermoplastic antistatic film. Also such antistatic containers are useful to make a package for devices in a medical operating room where explosive oxygen and/or ether are present and thus protection from static electricity must be provided. Also such antistatic containers may be advantageously employed for any use requiring a plastic with a decreased tendency to accumulate dust.

### Background of the Invention

It is known in the art to produce various shaped rigid articles from foamed and unfoamed thermoplastic materials such as polyethylene terephthalate or polystyrene sheet by thermoforming methods. The rigid articles may be trays and lids therefor, useful for packaging products to protect them from physical damage. They may be in a "clam shell" shape, having a bottom portion attached by a hinge to a lid, so when folded over and sealed this would envelope a product. Many such articles are used for packaging electronic components. However, it is desired that such rigid containers be antistatic, which thermoplastic polymers are not. Rather, thermoplastic polymers are typically insulators and hold a charge.

When two surfaces are brought in contact with each other, a transfer of electrons may occur resulting in a residual static electrical charge when the surfaces are separated. This phenomena is known as tribo-electricity. If the surface is composed of a material that is a conductor, the electrons will dissipate quickly thereby eliminating the excess charge. On the other hand, if the surface is composed of a material that is an insulator (a dielectric), the surface charge takes much longer to dissipate. Thermoplastic polymers are typically excellent insulators and thus are unsatisfactory for uses requiring a nature that will dissipate charges. The polymers accumulate or hold high charges promoting an attraction for dust and dirt. The polymers can discharge to any lower potential body with which they come in contact and harm sensitive items. To modify a polymer to have antistatic characteristics and dissipate charges, the conductivity might be increased which in turn causes an increase in the rate of static dissipation. This has been accomplished in the past by the use of antistatic agents to promote static-charge decay of surfaces thereby reducing clinging effect, eliminating harmful static discharge, and preventing accumulation of dust. For instance, it is known that loading a plastic with carbon will impart antistatic characteristics thereto, so carbon loaded rigid thermoplastic trays have been tried in the past. However, a drawback is that the carbon sloughs and contaminates an electronic component packaged in such a tray.

It is well known that static charge can be reduced by increasing the moisture content of the atmosphere, and thus the approach in the past has been to use an antistatic agent which will modify the inherently dielectric polymer to impart hydrophilic properties to it by providing functional groups that attract moisture to it. For instance, it is well known to employ internal antistatic agents which are volume dispersed by admixing in the polymer, i.e. incorporated into the polymer by compounding or extrusion prior to or during molding or thermoforming operations to make a rigid container, and which work by migrating to the polymer surface. This migration is colloquially referred to in the art of antistatic polymer technology as a "blooming" or "bleeding" effect. When the antistatic agent has not remained volume dispersed but instead has bloomed or bled to the surface, the atmospheric moisture is attracted causing decay or dissipation of static charges. Thus, the antistatic characteristic of the thermoplastic container depends on ambient humidity. Accordingly a high rate of blooming is required. The Federal Test Method requires that the static decay time test be performed in a "dry" atmosphere, i.e. about 150 relative humidity or less. Such prior containers may not be antistatic under relatively dry conditions, i.e. a relative humidity under about 15%. In other words, prior antistats need a typical ambient atmosphere of 40 to 50% RH to work, and they behave as insulators under "dry" conditions of 15% or less. Moreover they can overbloom and lose their antistatic character if subjected to a 24 hour water shower or a prolonged heat exposure, such as 12 days in a hot (about 70 °C) oven.

### Object

It is an object of the invention to provide a method and product for a rigid antistatic container, employing material that is dielectric, i.e. an insulator. It is a feature that rigid dielectric sheet, which heretofore could not be safely used to package static sensitive devices like circuit boards, can now be used to package such devices.

## Summary of the Invention

Thus, the present invention provides an antistatic rigid container comprising a laminate of a thermoplastic rigid sheet and an antistatic flexible film.

Also, the invention provides a method of making an antistatic rigid container from a dielectric rigid sheet, said container being suitable for protecting static sensitive devices, comprising forming a container from a rigid dielectric sheet having an antistatic flexible film adhered to it.

Also, the invention provides a package comprising a static sensitive device enveloped within a rigid antistatic container of a laminate of a rigid dielectric sheet and an antistatic flexible film.

## Description of Drawings

Figure 1 shows a package 2 in cross section comprising contents 10, laminate tray 4 of thermoplastic rigid dielectric sheet and thermoplastic antistatic flexible film, and lid 6 of thermoplastic rigid dielectric sheet and thermoplastic antistatic flexible film. Heat seals 8, 8A join the tray 4 and the lid 6 and form rigid antistatic container 12. Enveloped therein is static sensitive contents 10 such as an electronic circuit board.

Figure 2 is a blow-up of portion of tray 4 of Figure 1 which shows in cross section rigid dielectric sheet 14 having adhered thereto antistatic flexible film 16, 16A, thereby forming a wall of a rigid antistatic container. Alternatively, sheet 14 could have flexible film 16 adhered to one surface, the interior one that contacts the static sensitive device 10 but it is preferred that the antistatic film 16, 16A is adhered to both surfaces of rigid sheet 14.

## Detailed Description of the Invention

Any rigid thermoplastic sheet may be employed for making the laminate container. A rigid tray and lid therefor is formed from the sheet by well known techniques, e.g., vacuum thermoforming from a material. Thermoforming processes and machinery therefor are well known and are not intended to be part of the invention. Any conventional thermoforming equipment suitable for thermoforming rigid materials may be employed. The material may be composed of a single-ply polymeric sheet such as polyethylene terephthalate (designated herein as PET), polyvinylchloride (designated herein as PVC), nylon, acrylonitrile, polypropylene, polyester, fluorohalocarbon, polyurethane, ethylene vinyl alcohol, polystyrene, or a multi-ply composite of polymeric materials including the multi-ply structures: PVC/polyolefin, PVC/saran, PVC/saran/polyolefin, PVC/saran/ethylene vinylacetate copolymer, polystyrene/saran/polyolefin, polystyrene/saran copolymer, nylon/saran/polyolefin, polyolefin/saran/ polyethylene, polyester/saran/polyolefin, polycarbonate/saran/polyolefin, polyolefin/adhesive/ethylene vinyl alcohol/adhesive/polyolefin or many other such materials which are well known in the art. The essential requirements of the tray and lid are that they be formed of sheet materials or composites which have adequate thermal formability, and have generally good physical strength characteristics, i.e. are rigid. A wide latitude of thicknesses may be employed limited only by economical or practical requirements. Of course, it is well known that the tray and lid may be of unitary construction joined by a hinge (i.e. a "clam shell"), or may be two separate pieces. Hereinafter, tray and lid will be intended to include either construction, whether unitary or two pieces.

It is noted some of the thermoplastic materials suitable for the rigid thermoplastic sheet are "barrier" polymers. "Barrier" polymer refers to a property in some thermoplastic materials which indicates that the particular material has a very low permeability to gases, such as oxygen, i.e. a low oxygen transmission rate. One barrier polymeric material is vinylidene chloride copolymer, designated as "PVDC". Typical

vinylidene chloride copolymers include but are not limited to vinylidene chloride-vinyl chloride and vinylidene chloride-methyl acrylate. Vinylidene chloride copolymer is also commonly known as saran which has, in the United States, become generic and is not a registered trademark. Another known barrier polymeric material is acrylonitrile, herein abbreviated as AN. Another is hydrolyzed ethylene-vinyl acetate copolymer, which is also called saponified ethylene-vinyl acetate copolymer or ethylene-vinyl alcohol copolymer or hydrolyzed ethylene-vinyl acetate copolymer. This is designated by the abbreviations: "EVOH" or "HEVA". Sometimes it is referred to as "EVAL" which is a trademark, of Kuraray Co. Ltd. for EVOH. Nylon is also a suitable barrier material.

Limits for oxygen, or other vapors, may vary depending on the products the film is intended for. For a thermoplastic polymer to be designated as oxygen barrier, for current commercial purposes, a permeability below 70 cc.mil thickness/$m^2$.atmosphere.day at room temperature (which is equivalent to about 4.5 cc.mil thickness/100 $in^2$.atmosphere.day at room temperature) is expected and a permeability below about 50 cc.mil thickness/$m^2$.atm.day (about 3.2 cc mil thickness/100 $in^2$.atm.day) is highly desirable. Even more preferably the permeability is below about 10 cc.mil thickness/$m^2$.atm.day (about 0.64 cc.mil thickness/100 $in^2$.atm.day). The test for oxygen transmission is conducted as per ASTM D3985. Similarly, commercially desirable transmission rates exist for other gases such as $H_2O$ vapor or $CO_2$ depending on the specific product the film is intended for. For instance, polyethylene terephthalate is a good moisture barrier.

The advantage of oxygen barrier materials is the oxygen is prevented from permeating into the package and corroding the product, such as an electronic circuit board, packaged therein.

But, as mentioned above, thermoplastic polymers are inherently dielectric or insulative and they will hold for more than 5 seconds a thousand volts or more of static charge. The rigid tray and lid are not antistatic. Therefore, a flexible antistatic film is adhered directly to the rigid material to make an antistatic rigid container. Depending on the flexible film and the rigid material, adhesive may be employed between the two. This may be achieved by laminating. Laminating processes and machinery therefor are well known and are not intended to be part of the invention. Any conventional laminator suitable for laminating a flexible material to a rigid material may be employed. Typical laminating processes and machinery for laminating a flexible material onto a rigid material are disclosed in in U. S. Patent 4,214,936 (1980) Bianco assignor to du Pont and in U. S. Patent 4,193,830 (1980) Milne assignor to Pace, the disclosures of which are incorporated herein by reference.

Also, with the proper kind of coextrusion die, the rigid sheet and antistatic flexible film can be coextruded to form a laminate. Such coextrusion processes and machinery therefor are well known and are not intended to be part of the invention.

Thus, the term "laminate" as used herein is intended to mean the rigid sheet with the flexible film adhered thereto, whether made by laminating techniques or coextrusion.

As the flexible film is antistatic, the laminate of the rigid tray and lid with the flexible film adhered thereto is an antistatic rigid container and will exhibit a static decay time of 3000 ms or less when tested at room temperature at a low humidity of 15% RH or less.

Any flexible antistatic film may be employed. Preferred is the permanent antistatic film of quaternary amine and acid copolymer in accordance with copending applications USSN 143,385 filed January 14, 1988, and USSN 249,488 filed September 26, 1988, both to Havens and Roberts, corresponding to EP-A-0,324,494 (89 100 522.5-2102), the disclosures of which are incorporated herein by reference. USSN 249,488 is a Continuation in Part of USSN 143,385.

There is not necessarily a correlation between the "antistatic" surface or volume resistivity of a film and the "antistatic" ability of a film to decay or dissipate charges as per the static decay time Federal test 101c, Method 4046.1. Surface resistivity and volume resistivity are tested according to ASTM D257.

The Department of Defense and the Electronics Industry Association have standards on surface resistivity of a material in ohms/square as follows:

| Surface Resistivity Ranges (ohms/square) | | |
| --- | --- | --- |
| Insulative | Antistatic or Static Dissipative | Conductive |
| greater than $10^{12}$ | $10^{12}$ to $10^{5}$ | less than $10^{5}$ |

Thus, the term "antistatic" as used herein describes a material which can dissipate 99% of an applied static charge of ±5000 Vdc in a short amount of time, preferably a static decay time less than about 3

seconds, more preferably less than about 2 seconds (Federal Test Method Standard 101c, Method 4046.1, "Electrostatic Properties of Materials"), the static decay time test being performed at about room temperature at a low humidity of about 15% or less relative humidity. If the material also happens to have an antistatic resistivity, i.e. a surface resistivity of about $10^5$ to $10^{12}$ ohms/square, then that material will be described using the term "antistatic surface resistivity".

The preferred antistatic flexible film of quaternary amine and acid copolymer has permanent, non-bleeding antistatic characteristics. By "permanent, non-bleeding" antistatic characteristics is meant the flexible film exhibits a static decay time (hereinafter abbreviated as SDT) under about 3000 milliseconds (hereinafter abbreviated as ms) when the static decay test using 5000 volts direct current (hereinafter abbreviated as Vdc) is conducted as per Federal Test Method 101c, Method 4046.1, after a 24-hour water shower, i.e. the antistatic property is not washed out by the shower. In the preferred embodiments, the film will also still have this SDT of about 3000 ms or less even after 12 days in a hot (approximately 70° C) oven. In the especially preferred embodiments, in addition to having an SDT of about 3000 ms or less after a 24-hour water shower and after 12 days in a70° C oven, the flexible film will also have "permanent antistatic surface resistivity". By "permanent antistatic surface resistivity" is meant an antistatic surface resistivity of about $10^5$ to $10^{12}$, after a 24-hour water shower or after 12 days in a 70° C oven.

Most preferred as the flexible film for laminating to the rigid sheet are some of the multi-ply flexible antistatic films of quaternary amine and acrylic acid copolymer (see Examples XIII and XIV below). These have both a preferred static decay time of about 3000 milliseconds or less and an antistatic surface resistivity of $10^{12}$ to $10^5$ ohms/square, even after a 24-hour water shower, and after 12 days in a hot (about 70° C) oven. Thus these are permanently antistatic by the definition of static decay time and also have a permanent antistatic surface resistivity by the definition of surface resistivity; the 24-hour water shower and the 12-day hot oven do not take out the "antistatic" characteristic.

For clarity regarding the preferred flexible antistatic films disclosed in copending USSN 249,488 and USSN 143,385, pertinent portions of the Continuation in Part USSN 249,488 are repeated below.

As mentioned above, the preferred flexible antistatic film comprises quaternary amine and acid copolymer.

The acid copolymer is a polymer containing carboxylic acid moieties. By "polymers containing carboxylic acid moieties" as that term is used herein it is intended to mean copolymers of (i) a major amount by mol % of an alpha-olefin having the formula $RCH=CH_2$ wherein R is H or $C_1$ to $C_{20}$ alkyl and (ii) a minor amount by mol % of an alpha,beta-ethylenically unsaturated carboxylic acid. When R is alkyl, preferably R is $C_1$ to $C_8$ alkyl Preferably, the alpha-beta-ethylenically unsaturated carboxylic acid is present in an amount by mol % of about 40% or less, more preferably about 30% or less, most preferably about 20% or less. Also, by the term "polymers containing carboxylic acid moieties", it is intended to mean that the copolymer of an alpha-olefin having the formula $RHC=CH_2$ wherein R is H or $C_1$ to $C_8$ alkyl and an alpha,beta-ethylenically unsaturated carboxylic acid may be wholly or partially neutralized with a suitable cation such as zinc cation or sodium cation. Thus, the polymer containing carboxylic acid moieties may be an ionomer.

The acid copolymer need not necessarily comprise a two component polymer. Thus, although the olefin content of the acid copolymer is at least 50 mol percent, preferably at least 60%, more than one olefin may be employed. Also, other copolymerizable monoethylenically unsaturated monomers may be employed in combination with the olefin and the carboxylic acid comonomer. It is intended also to include terpolymers. Accordingly, acid copolymers or terpolymers suitable for use in the present invention include, but are not limited to, ethylene/acrylic acid copolymers, ethylene/methacrylic acid copolymers, ethylene/itaconic acid copolymers, ethylene/methyl hydrogen maleate copolymers, ethylene/maleic acid copolymers, ethylene/methyl hydrogen maleate/ethyl acrylate terpolymers, ethylene/methacrylic acid/vinyl acetate terpolymers, ethylene/acrylic acid/vinyl acetate terpolymers, ethylene/acrylic acid/vinyl alcohol terpolymers, ethylene/propylene/acrylic acid terpolymers, ethylene/styrene/acrylic acid terpolymers, ethylene/ acrylic acid/methyl methacrylate terpolymers, ethylene/methacrylic acid/ ethyl acrylate terpolymers, ethylene/itaconic acid/methyl methacrylate terpolymers, ethylene/methacrylic acid/acrylonitrile terpolymers, ethylene/ fumaric acid/vinyl methyl ether terpolymers, ethylene/vinyl chloride/acrylic acid terpolymers, ethylene/vinylidene chloride/acrylic acid terpolymers, ethylene/vinyl flouride/methacrylic acid terpolymers, and ethylene/ chlorotrifluroethylene/methacrylic acid terpolymers.

The copolymer of an alpha-olefin having the formula $RCH=CH_2$ wherein R is H or $C_1$ to $C_{20}$ alkyl and an alpha,beta-ethylenically unsaturated carboxylic acid representatively may be produced by the free radical copolymerization of ethylene and a carboxylic acid comonomer therefor such as acrylic acid or methacrylic acid. Suitable such acid copolymers are the Primacor™ polymers, supplied by Dow Chemical Company, Midland, Michigan. Primacor is produced by the copolymerization of ethylene and acrylic acid.

Ethylene-acrylic acid copolymers are herein referred to as EAA copolymer. A very suitable Primacor polymer is Primacor 1410 or Primacor 5981. Other suitable such acid copolymers are sold under the tradename Nucrel by du Pont; they are produced by the copolymerization of ethylene and methacrylic acid. Ethylene-methacrylic acid copolymers are herein referred to as EMAA copolymers. Ionomers are commercially available as Surlyn® from the E. I. du Pont de Nemours Company of Wilmington, Delaware, and are described in detail in US Patents 3,355,319 and 3,845,163.

The amine is a quaternary amine of the formula $[(R^1)(R^2)(R^3)(R^4)\overset{+}{N}][X]^-$ wherein

$R^1$ is selected from H, aryl, or $C_1$ to $C_{50}$ alkyl optionally having one or more non-contiguous C=O or NHC=O or -S- or -O- in the carbon chain, or the same as $R^2$;

each of $R^2$, $R^3$, and $R^4$ is the same or different and selected from H, from $C_1$ to $C_{18}$ alkyl optionally substituted with one or more OH, or from $-(R^5-O)_a-H$ where a is an, integer from 1 to 10 and $R^5$ is ethylene or propylene; and

X is an anion selected from chloride, bromide, iodide, fluoride, nitrate, fluoborate, phosphate, $C_1$ to $C_{20}$ alkyl phosphate, sulfate, $C_1$ to $C_{20}$ alkyl sulfate, formate, $C_1$ to $C_{20}$ alkyl or $C_6$ to $C_{24}$ alkaryl or aryl sulfonate, acetate, trifluoroacetate, citrate, propionate, tartrate or carbonate.

Preferably, the $C_1$ to $C_8$ alkyl phosphate is methyl phosphate or ethyl phosphate, the $C_1$ to $C_{20}$ alkyl sulfate is methyl sulfate or ethyl sulfate, and the $C_1$ to $C_{20}$ alkyl or $C_6$ to $C_{24}$ alkaryl or aryl sulfonate is methanesulfonate, butanesulfonate, benzenesulfonate, or $C_1$ to $C_{18}$ alkyl benzenesulfonate.

By "quaternary amine" as that term is employed herein, it is intended to include quaternary ammonium compounds and/or quaternary ammonium salts.

Suitable quaternary amines (QA) may be chosen from, but are not limited to, the methyl chloride salts of ethoxylated fatty amines. Commercial ones are available from the Tomah Division (Milton, Wisconsin) of Exxon Chemical and are represented by the formula:

$$(CH_2CH_2O)_qH$$

$$|$$

$$Z-N-CH_3^+ \qquad Cl^-$$

$$|$$

$$(CH_2CH_2O)_tH$$

where Z is an alkyl or alkoxy radical, and q + t is the total number of moles of ethylene oxide in the chains. Examples of commercially available ones are as follows:

| COMMERCIAL QUATERNARY AMINES | | |
|---|---|---|
| QA Product Indentification Number | Z | q + t |
| Q-14-2 | $C_{10}OC_3$ | 2 |
| Q-14-5 | $C_{10}OC_3$ | 5 |
| Q-14-15 | $C_{10}OC_3$ | 15 |
| Q-17-2 | $C_{13}OC_3$ | 2 |
| Q-S-2 | Soya | 2 |
| Q-S-5 | Soya | 5 |
| Q-S-15 | Soya | 15 |
| Q-18-2 | $C_{18}$ | 2 |
| Q-18-5 | $C_{18}$ | 5 |
| Q-18-8 | $C_{18}$ | 8 |
| Q-18-10 | $C_{18}$ | 10 |
| Q-18-15 | $C_{18}$ | 15 |
| Q-T-2 | Tallow | 2 |
| Q-T-5 | Tallow | 5 |
| Q-T-15 | Tallow | 15 |
| Q-DT-3 | "Tallow Diamine" | 3 |

Other very suitable quaternary amines are the ethyl sulfate salts or methyl sulfate salts of alkoxylated fatty amines. Commercial ones are available under the trade-name Emerstat 6660 from Emery Industries and it is believed from applicants' own chemical analysis that they are represented by the formula: $(A)(A')N-[(CH_2CH_2O)_nH]_2^+\ A'OSO_3$-where A is $C_8$ to $C_{20}$ alkyl, A' is ethyl and n is an integer from 1 to 4. Also suitable are methyl sulfate salts such as that sold under the trade-name Cyastat by Cyanamid; it has the formula $C_{11}H_{23}CONHC_3H_6N(CH_3)_3^+CH_3OSO_3^-$. Also suitable are ethosulfate salts such as that sold under the trade-name Larostat 264A Anhydrous, which is a modified soyadimethyl ethylammonium ethosulfate.

Additional QA's may be prepared by reacting a tertiary amine (TA) and an acid or alkylating agent, as further described in the Example VI below.

The polymer containing carboxylic acid moieties and the quaternary amine are combined by mixing with heat. Optionally, a polymer compatible therewith, such as a polyolefin, may be blended in the mixture. Any suitable mixing means may be employed such as a blender or a twin screw extruder. The heat should be from about 50° C to 290° C, more preferably about 100° C to 250° C, even more preferably about 100° C to 200° C. Then the resultant may be formed into a flexible film such as by heat pressing on a platen or by any of the various methods further discussed below. The flexible film is permanently antistatic. It will dissipate an applied charge of ±5000 Vdc in less than about 3000 ms, more preferably less than 2000 ms, using the method described in Federal Test Method Standard 101c, Method 4046.1, even after a 24 hour water shower. This is unlike prior polymeric films containing an antistatic agent to give them antistatic characteristics, which characteristics can be washed out after a 24 hour water shower because the agents operate by migrating to the surface and attracting moisture. Furthermore, in some embodiments, the present films survive 1 day, more preferably 3 days, even more preferably 5 days, and most preferably 12 days in a hot oven at approximately 70° C and still exhibit this static decay time of less than about 3000 ms, more preferably less than about 2000 ms.

Based on the % weight amount of polymer containing carboxylic acid moieties, it is preferred that the quaternary amine be present in a weight % amount up to about 50%, more preferably up to about 30%, even more preferably up to about 20%. Based on the total composition weight, which optionally may oontain polyolefin, preferably the quaternary amine is present in a weight % amount of about 0.001% to about 30%, more preferably about 0.01% to about 20%, and even more preferably about 2% to about 10%.

It is also noted that in multi-layer film embodiments, the layer or layers of composition of quaternary amine and acid copolymer should comprise about half the thickness or more of the multi-layer film for the film to be permanently antistatic, i.e., exhibit an SDT under 3000 ms after a 24-hour water shower. Otherwise, the film "as is" will exhibit an SDT under 3000 ms, but after the 24-hour water shower, the film typically won't accept a charge. It is also further preferred that both skin layers of the multi-layer film comprise the composition of quaternary amine and acid copolymer, as compared to 1 skin layer or a core

layer, for the film to have a permanent antistatic surface resistivity, i.e. a surface resistivity from $10^5$ to $10^{12}$ ohms/square after a 24-hour water shower. All of this is illustrated by Example XII below wherein the multi-layer film had only 1/5 its thickness (i.e. 1 layer out of 5) be the composition of quaternary amine and acid copolymer. This film exhibited an antistatic SDT of 1824 ms and 1852 ms when tested "as is", but would not accept a charge after a 24-hour water shower. Also this film exhibited an antistatic surface resistivity of $5.9 \times 10^{11}$ ohms/square when tested "as is", but showed an insulative surface resistivity of $1.9 \times 10^{14}$ ohms/square after a 24-hour water shower.

Many polymer resins are suitable polymers for blending with the new, acid copolymer/quaternary amine. Unless specifically set forth and defined or otherwise limited, the terms "polymer" or "polymer resin" as used herein generally include, but are not limited to, homopolymers, copolymers, such as, for example block, graft, random and alternating copolymers, terpolymers etc. and blends and modifications thereof. Furthermore, unless otherwise specifically limited the terms "polymer" or "polymer resin" shall include all possible structures of the material. These structures include, but are not limited to, isotactic, syndiotactic and random symmetries. Particularly suitable for blending are the polyolefins. The term "polyolefin" as used herein generally includes, but is not limited to, materials such as polyethylene (PE), polypropylene (PP), ethylene-vinyl acetate (EVA) and the like, the homopolymers, copolymers, terpolymers etc. thereof, and blends and modifications thereof. The term "polyolefin" shall include all possible structures thereof, which includes, but is not limited to, isotactic, syndiotactic and random symmetries.

According to Modern Plastics Encyclopedia, 1985-86, polyethylenes having densities ranging from about 0.900 g/cc to about 0.935 g/cc are called low density polyethylenes (LDPE), while those having densities from about 0.936 g/cc to about 0.940 g/cc are called medium density polyethylenes (MDPE), and those having densities from about 0.941 g/cc to about 0.965 g/cc and over are called high density polyethylenes (HDPE). The older, classic low density types of polyethylenes are usually polymerized at high pressures and temperatures whereas, the older, classic high density types are usually polymerized at relatively low temperatures and pressures. The term "linear low density polyethylene" (LLDPE) as used herein, for a type of polyolefin, refers to the newer copolymers of a major amount of ethylene with a minor amount of one or more comonomers selected from $C_3$ to $C_{10}$ alpha olefins such as butene-1, pentene-1, hexene-1, 4-methyl-pentene-1, octene-1, etc. in which the molecules thereof comprise long chains with few side chains or branched structures achieved by low pressure polymerization. LLDPE has a density preferably in the range from about 0.911 g/cc to about 0.935 g/cc, and more preferably in the range of from about 0.912 g/cc to about 0.928 g/cc. Also, very low density linear low density polyethylenes (VLDPE) may be employed, and such have a density from about 0.910 g/cc to about 0.860 g/cc, or even lower.

The term "ethylene vinyl acetate copolymer" (EVA) as used herein, for a type of polyolefin refers to a copolymer formed from ethylene and vinyl acetate (VA) monomers. The ethylene derived units in the copolymer are present in major amounts by weight and the VA derived units in the copolymer are present in minor amounts by weight. For film making purposes, it is preferred that the VA content of the EVA be from about 3% to about 25%.

The term "polypropylene" (PP) as used herein for a type of polyolefin refers to polymers of propylene, and includes homopolymers, copolymers, such as for example block, graft, random, and alternating, copolymers, terpolymers etc. and blends and modifications thereof.

The term "ethylene/alkyl-acrylate copolymer" (EA1Acr) as used herein refers to a copolymer formed from ethylene and alkyl acrylate wherein the alkyl moiety has 1 to 8 carbon atoms and the ethylene derived units in the copolymer are present in major amounts by weight and the alkyl-acrylate derived units in the copolymer are present in minor amounts by weight. Thus, the term "ethylene/methyl acrylate copolymer" (EMA) as used herein refers to a copolymer formed from ethylene and methyl acrylate monomers. The term "ethylene/ethyl acrylate copolymer" (EEA) as used herein refers to a copolymer formed from ethylene and ethyl acrylate monomers. The term "ethylene/butyl acrylate copolymer" (EBA) as used herein refers to a copolymer formed from ethylene and butyl acrylate monomers. Many suitable EBA's are commercially available and these have a butyl acrylate content from about 3% up to about 18% by weight. USI is a commercial supplier of Resin No. 4895, which is an EBA having about 3% by weight butyl acrylate and a melt index of about 3 and a melting point of about 106° to 110° C.

Blends of all families of polyolefins, such as blends of EVA, EA1Acr, PP, LDPE, HDPE, VLDPE, and LLDPE, may also be advantageously employed.

Measuring the antistatic property: The antistatic property is exhibited by the ability of the polymer containing the agent to promote static charge decay, i.e. to dissipate a static charge. The polymer alone will not dissipate a static charge, but the polymer containing the agent is able to dissipate 99% of an applied static charge of ±5000 volts direct current (Vdc) in a short amount of time, i.e. less than 3 seconds, more preferably less than 2 seconds (2000 milliseconds), at a "dry" ambient humidity, i.e. about 15% RH or less.

Federal Test Method Standard 101c, Method 4046.1, "Electrostatic Properties of Materials" states less than 2000 ms and thus it is preferred to have a material that complies with 101c. Decay meters for measuring the time for dissipation of the applied volts are commercially available, such as the 406C static decay meter supplied by Electrotech Systems, Inc. Unless otherwise indicated in the Examples below, the flexible films, prior to testing, were equilibrated at less than about 15% relative humidity (RH) at about room temperature (RT) for about 24 hours.

Some flexible films were tested for triboelectric charge generation. Two aluminum plates were used for this test. Plate 1 was a ground plane and was about 12 inches (30.5 cm) x 12 inches (30.5 cm) x 3/16 inch (0.5 cm) in size. Plate 2 was about 4 inches (10.2 cm) X 3 inches (7.6 cm) X 3/16 inch (0.5 cm) in size and had a non-contacting static voltmeter attached to it. Plate 2 also had an insulating rod or handle attached to it to allow the person performing the test to separate the plates without touching them and affecting the charge accumulation. The material under test was placed on Plate 1. Plate 2 was pushed against the material to make intimate contact with the sample. Plate 2 was then separated rapidly up against a stop, while the sample remained in contact with Plate 1. This stop limited the travel to approximately 1 inch (2.54 cm) of separation between the two plates. This procedure was repeated 4 times and the voltmeter readings averaged. The principle of this measurement is that when two materials are placed in contact and then separated they give up or take on electrons thus leaving both materials with a net charge. Since one of the materials in the test is a metal plate, the charge on it can be measured by a static voltmeter. The magnitude and polarity of the charge is then an indicator of the tribo-charging propensity of the material under test. A desirable reading is between about -200 volts and +200 volts.

Some of the flexible films were tested for surface resistivity and volume resistivity according to ASTM D257. There is not necessarily a correlation between the surface or volume resistivity of a film and the ability of a film to decay or dissipate charges. Thus, the term "antistatic" as used herein describes a material which can dissipate 99% of an applied static charge of ±5000 Vdc in a short amount of time, preferably a static decay time less than about 3 seconds, more preferably less than about 2 seconds (Federal Test Method Standard 101c, Method 4046.1, "Electrostatic Properties of Materials"), at a "dry" ambient humidity, i.e. about 15% RH or less.

As mentioned above, the Department of Defense and the Electronics Industry Association have standards on surface resistivity of a material in ohms/square as follows:

| Surface Resistivity Ranges (ohms/square) | | |
|---|---|---|
| Insulative | Antistatic or Static Dissipative | Conductive |
| greater than $10^{12}$ | $10^{12}$ to $10^{5}$ | less than $10^{5}$ |

It is noted that some of the multi-layer films of the invention, as illustrated by Examples XIII and XIV below, have both a preferred static decay time of about 3000 milliseconds or less and a static dissipative (as opposed to insulative) surface resistivity of $10^{12}$ to $10^{5}$ ohms/square, even after a 24-hour water shower or 12 days in a hot oven. Thus these films are permanently antistatic by the definition of static decay time and permanently antistatic by the definition of antistatic surface resistivity; neither the 24-hour water shower nor the 12-day hot oven takes out the "antistatic" characteristic.

Some of the films were tested for induction of crazing in polycarbonate, i.e. polycarbonate compatibility, which was a test developed by General Electric Company, published as their "LEXAN® Resin Technifacts" T-47 test method. This test consists of bending or flexing test coupons or bars of LEXAN® about 1/8 inch (0.32 cm) thick on metal jigs to several known stress levels of about 500 to 3400 psi (35 to 239 kg/cm²) and the material being evaluated is then applied to the stressed coupons and the combination maintained at several temperatures for 5 days. The temperatures are about 73° F (22.8° C), 120° F (48.9° C), 158° F (70° C), and 185° F (85° C). A comparison of the strain independent of the material being evaluated, the radius of the curvature of the upper surface of the jig, and the stress level of the LEXAN® bars is as follows:

| STRESS LEVEL 1/8" THICK BARS UNFILLED LEXAN RESIN | | RADIUS OF UPPER SURFACE OF JIG | | STRAIN INDEPENDENT OF MATERIAL |
|---|---|---|---|---|
| PSI | $kg/cm^2$ | Inches | cm | Percent |
| 500 | 35 | 42.437 | 107.8 | 0.15 |
| 750 | 53 | 28.270 | 71.8 | 0.22 |
| 1000 | 70 | 21.187 | 53.8 | 0.29 |
| 1250 | 88 | 17.063 | 43.3 | 0.37 |
| 1500 | 105 | 14.103 | 35.8 | 0.44 |
| 1750 | 123 | 12.080 | 30.7 | 0.51 |
| 2000 | 141 | 10.563 | 26.8 | 0.59 |
| 2250 | 158 | 9.381 | 23.8 | 0.66 |
| 2500 | 176 | 8.437 | 21.4 | 0.74 |
| 2750 | 193 | 7.664 | 19.5 | 0.81 |
| 3000 | 211 | 7.020 | 17.8 | 0.88 |
| 3400 | 239 | 6.187 | 15.7 | 1 |

At the end of the exposure, the bars are visually checked for crazing. Results are reported as the maximum stress to which the bar can be subjected while in contact with the particular environment without the occurrence of crazing. It is desired that the film exhibit no crazing or only very slight crazing at a temperature 158°F (70°C) and stress of 1700 psi, more preferably a temperature of 185°F (85°C) and stress of 1700 psi.

Manufacture of flexible films: Typically, in the manufacture of films, a suitable polymer usually in the form of pellets or the like, is brought into a heated area where the polymer feed is melted and heated to its extrusion temperature and extruded as a tubular "blown bubble" through an annular die. Other methods, such as "slot die" extrusion wherein the resultant extrudate is in planar, as opposed to tubular, form are also well known. If heat shrinkable film is desired, then after extrusion, the film is typically cooled and then reheated and stretched, i.e. oriented by "tenter framing" or by inflating with a "trapped bubble", to impart the heat-shrinkable property to the film, as is further described below. If desired, high energy irradiation, typically via an electron beam, preferably takes place prior to the stretching for orienting the film. However, for the present invention, such irradiation is not necessary since a very suitable packaging film having permanent antistatic characteristics is obtained without irradiation. Below, first is described the general process for making and orienting film. Then irradiation is described.

More particularly, manufacturing of films may be accomplished as follows. For instance, the manufacture of shrink films may be generally accomplished by extrusion (single layer films) or coextrusion (multi-layer films) of thermoplastic resinous materials which have been heated to or above their flow or melting point from an extrusion or coextrusion die in, for example, either tubular or planar (sheet) form, followed by a post extrusion cooling. The stretching for orientation may be conducted at some point during the cool down and while the film is still hot and within its orientation temperature range followed by completing the cooling. Alternatively, after the post extrusion cooling, the relatively thick "tape" extrudate is then reheated to a temperature within its orientation temperature range and stretched to orient or align the crystallites and/or molecules of the material and then cooled. The orientation temperature range for a given material or materials will vary with the different resinous polymers and/or blends thereof which comprise the material. However, the orientation temperature range for a given thermoplastic material may generally be stated to be below the crystalline melting point of the material but above the second order transition temperature (sometimes referred to as the glass transition temperature) thereof. Within this temperature range, the material may be effectively oriented. The terms "orientation" or "oriented" are used herein to describe generally the process steps and resultant product characteristics obtained by stretching and immediately cooling a resinous thermoplastic polymeric material which has been heated to a temperature within its orientation temperature range so as to revise the intermolecular configuration of the material by physical alignment of the crystallites and/or molecules of the material to improve certain mechanical properties of the film such as, for example, shrink tension and orientation release stress. Both of these properties may be measured in accordance with ASTM D 2838-81. When the stretching force is applied in one direction monoaxial orientation results. When the stretching force is simultaneously applied in two directions biaxial orientation results. The term oriented is also herein used interchangeably with the term "heat-shrinkable"

with these terms designating a material which has been stretched and set by cooling while substantially retaining its stretched dimensions. An oriented (i.e. heat-shrinkable) material will tend to return to its original unstretched (unextended) dimensions when heated to an appropriate elevated temperature.

An "oriented" or "heat-shrinkable" material is defined herein as a material which, when heated to an appropriate temperature above room temperature (for example 96° C), will have a free shrink of about 5% or greater in at least one linear direction. The stretching to orient may be accomplished in many ways such as, for example, by "trapped bubble" techniques or "tenter framing". These processes are well known to those in the art and refer to orientation procedures whereby the material is stretched in the cross or transverse direction (TD) and/or in the longitudinal or machine direction (LD or MD).

Of course, laminating a heat-shrinkable flexible film to the rigid sheet will negate the shrink property. Nevertheless, it may be desirable to employ a heat-shrinkable film anyway, as heat-shrinkable films can often be made much thinner than hot blown films. Thus, it may be desirable to anneal a heat-shrinkable antistatic flexible film to a rigid tray.

Of course, if a film having little or no orientation is desired, e.g. non-oriented or non-heat shrinkable film, the film may be formed from a non-orientable material or, if formed from an orientable material may be formed from a tube by using a "trapped bubble" technique commonly known as the "hot blown" technique. In forming a hot blown film, the tube is not cooled initially after extrusion or coextrusion but rather is first stretched by a hot blown bubble essentially immediately after extrusion while the tube is still at an elevated temperature above the orientation temperature range of the material. Thereafter, the film is cooled, by well-known methods. Those of skill in the art are well familiar with this process and the fact that the resulting film has substantially unoriented characteristics. Other methods for forming unoriented films are well known. Exemplary, is the method of cast extrusion or cast coextrusion which, likewise, is well known to those in the art.

Alternative methods of producing films are known to those in the art. One well-known alternative is the method of forming a multi-layer film by an extrusion coating rather than by an extrusion or coextrusion process as was discussed above. In extrusion coating a first tubular layer is extruded and thereafter an additional layer or layers is simultaneously or sequentially coated onto the outer surface of the first tubular layer or a successive layer.

The above general outline for manufacturing of films is not meant to be all inclusive since such processes are well known to those in the art. For example, see US Patent Nos. 4,274,900; 4,229,241; 4,194,039; 4,188,443; 4,048,428; 3,555,604; 3,741,253; 3,821,182 and 3,022,543. The disclosures of these patents are generally representative of such processes and are hereby incorporated by reference.

Many other process variations for forming films are well known to those in the art. For, example, conventional pressing, thermoforming or laminating techniques (including corona laminating) may be employed. For instance, multiple layers may be first coextruded with additional layers thereafter being laminated thereon, or two multi-layer tubes may be coextruded with one of the tubes thereafter being laminated onto the other.

Also, it is reiterated that, as mentioned above, with the proper kind of extrusion die, the rigid sheet and the flexible antistatic film can be coextruded. Typically, however, the flexible antistatic film would be laminated to the rigid sheet.

Irradiation, if desired, may be accomplished by the use of high energy electrons, ultra violet radiation, X-rays, gamma rays, beta particles etc. Preferably, electrons are employed up to about 20 megarads (Mr) dosage level. The irradiation source can be any electron beam generator operating in a range of about 150 kilovolts to about 6 megavolts with a power output capable of supplying the desired dosage. The voltage can be adjusted to appropriate levels which may be for example 1,000,000 or 2,000,000 or 3,000,000 or 6,000,000 or higher or lower. Many apparatus for irradiating films are known to those of skill in the art. The irradiation is usually carried out at a dosage between about 1 Mr (10 kilogrey) and about 20 Mr (200 kilogrey), with a preferred dosage range of about 2 Mr (20 kilogrey) to about 12 Mr (120 kilogrey). Irradiation can be carried out conveniently at room temperature, although higher and lower temperatures, for example, 0° C to 60° C may be employed.

It is also generally well known in the art that irradiation, such as by electron beam irradiation, of certain polymeric film materials generally results in a material having improved physical properties, such as abuse resistance, structural integrity, tensile strength, puncture resistance, and/or delamination resistance. Such physical toughness improvements from irradiation, are discussed in US Patent 3,022,543 (1962) to Baird et al, US Patent 4,178,401 (1979) to Weinberg and US Patent 3,741,253 to Brax et al.

Additives, e.g. antioxidants, UV stabilizers, antiblocking agents, colorants, and the like, may also be present. Advantageously, an outside polymeric layer of a film may include a small amount of about 10% by weight or less, more desirably about 7% by weight or less of an antiblock, to help alleviate any tackiness. A

suitable antiblock is EPE 8160 supplied by Teknor Apex.

The following Examples I-XIV are repeated here from copending USSN 249,488 to illustrate the preferred embodiments of the flexible antistatic film for use in the rigid laminate containers of the invention and comparisons thereto. Examples XV- XVIII illustrate the preferred embodiments of the invention of an antistatic rigid container comprising a rigid tray having a flexible antistatic film laminated thereto. It is not intended to limit the invention thereby.

Unless indicated otherwise in the Examples, the testing for static decay time (SDT) was done after equilibration for 24 hours, at about room temperature (RT), at less than about 15% relative humidity (RH). Also it is noted that sometimes SDT testing was done to samples that had been subjected to abuse such as 1 to 12 days in a hot, about 160°F (71°C), oven or a 24-hour water shower. Where the oven is designated as "humid", a beaker of water had been kept in the oven with the film sample during testing to maintain a "humid" atmosphere; otherwise the oven was simply a "dry" or "ambient" oven, without any water beaker.

## MATERIALS EMPLOYED IN THE EXAMPLES

| ANTIBLOCK | INGREDIENTS | SUPPLIER |
|---|---|---|
| EPE 8160 | Polyethylene Containing Micron Sized Silica | Teknor Apex |

| LLDPE | MI* | DENSITY | COMONOMER | SUPPLIER |
|---|---|---|---|---|
| DOWLEX 2045.03 | 1.1 | 0.920 | Octene | Dow Chemical |

| EVA | MI | % VA | COMONOMER | SUPPLIER |
|---|---|---|---|---|
| LD318.92 | 2.0 | 9 | Vinyl Acetate | Exxon |

| EAA | MI | % BY WEIGHT ACRYLIC ACID | % BY WEIGHT ETHYLENE | SUPPLIER |
|---|---|---|---|---|
| PRIMACOR 1410 | 1.5 | 9 | 91 | Dow Chemical |
| PRIMACOR 5981 | 300 | 20 | 80 | Dow Chemical |

| ZINC METHACRYLATE IONOMER OF EMAA | FORMULA | SUPPLIER |
|---|---|---|
| Surlyn 1650 | Partially zinc neutralized ethylene methacrylic acid copolymer | du Pont |

| QA | FORMULA | SUPPLIER |
|---|---|---|
| Q-14-2 | $[C_{10}H_{21}OC_3H_6N(C_2H_4OH)_2CH_3]^{+}Cl^{-}$ | Tomah Div. of Exxon |
| Emerstat 6660 | $[H(CH_2)_{8-20}](C_2H_5)N[(C_2H_4O)_{1-4}H]_2{+}\ C_2H_5OSO_3^{-}$ | Emery Industries |
| Cyastat | $C_{11}H_{23}CONHC_3H_6N(CH_3)_3^{+}CH_3OSO_3^{-}$ | Cyanamid |
| Larostat 264A Anhydrous | Modified soyadimethyl ethylammonium ethosulfate | Jordan/PPG/Mazer |

| TA | FORMULA | SUPPLIER |
|---|---|---|
| Empigen AB | Lauryl dimethylamine | Albright & Wilson |
| Empigen AY | $H(CH_2)_{10-18}(OC_2H_4)_{1-5}N(CH_3)_2$ | Albright & Wilson |
| E-14-2 | $C_{10}H_{21}OC_3H_6N(C_2H_4OH)_2$ | Tomah Div., Exxon |
| DMCA | N,N-dimethylcocoamine | Akzo Chemie |

| ACID OR ALKYLATING AGENT | FORMULA | SUPPLIER |
|---|---|---|
| MSA | Methanesulfonic Acid | Aldrich |
| DBSA | $H(CH_2)_{12-18}C_6H_4SO_3H$ | Alfa/Morton Thiokol |
| DES | Diethyl Sulfate | Aldrich |

*MI is melt index.

## EXAMPLE I

LLDPE and EAA (Primacor 5981) were premixed in parts by weight and then blended therein with heating was a QA in parts by weight. The resultant mix of LLDPE + EAA + QA was then further blended in an amount of 33-1/3% by wt. with EAA (Primacor 1410) in an amount of 66-2/3% by wt. and that was hot blown into an extruded, tubular film. Films were about 1.5 to 2 mils (0.04 to 0.05 mm) thick. What was made is listed in Table IA.

### TABLE IA

| | |
|---|---|
| 60 parts by wt LLDPE [Dowlex 2045.03]) | |
| 15 parts by wt QA [Q-14-2] ) | 33-1/3% by wt mix of LLDPE+EAA+QA |
| 30 parts by wt EAA [Primacor 5981] ) | |
| | 66-2/3% by wt EAA [Primacor1410] |
| | 100% Resultant Film |

Then, the following electrical measurements were taken on samples of film as reported in Table IB.

TABLE IB

| SAMPLE | | | |
|---|---|---|---|
| A | Static Decay Time as is | | 180 ms |
| B | Static Decay Time after 24 hours water shower | | 992 ms |
| C | Static Decay Time after days in hot oven at 71 °C | 3 days<br>5 days<br>9 days<br>12 days | 783 ms<br>1149 ms<br>7340 ms<br>14683 ms |
| D | Surface resistivity as is | $2x10^{10}$ ohms/square | |
| E | Volume resistivity as is | $8.7 \times 10^{10}$ ohm-cm | |
| • | after 24 hr. water shower | $1.5 \times 10^{12}$ ohm-cm | |
| | after 12 day dry oven | $1.8 \times 10^{14}$ ohm-cm | |

The results show the film performed well as an antistatic film both in terms of static decay time and resistivity, and was resistant to abusive aging, except that it did not survive 12 days in a hot oven with a desirable SDT of about 3000 ms or less.

## EXAMPLE II

Films were made as in Example I except that this time the QA was Emerstat 6660 supplied by Emery Industries. The resultant film that was made is as listed in Table IIA below.

TABLE IIA

60 parts by wt LLDPE [Dowlex 2045.03])
15 parts by wt QA [Emerstat 6660] ) 33-1/3% by wt Mix of LLDPE+EAA+QA
30 parts by wt EAA [Primacor 5981] )
66-2/3% by wt EAA [Primacor 1410]

100% Resultant Film

Then, the following electrical measurements were teen on samples of film as reported in Table IIB.

TABLE IIB

| SAMPLE | | | |
|---|---|---|---|
| A | Static Decay Time as is | | 209 ms |
| B | Static Decay Time after 24 hours water shower | | 539 ms |
| C | Static Decay Time after days in hot oven at 71 °C | 3 days<br>5 days<br>9 days<br>12 days | 78 ms<br>97 ms<br>361 ms<br>195 ms |
| D | Surface resistivity as is | $1.2 \times 10^{11}$ ohms/square | |
| E | Volume resistivity as is | $2.8 \times 10^{11}$ ohm-cm | |
| | after 24 hr. water shower | $2.2 \times 10^{12}$ ohm-cm | |
| | after 12 day dry oven | $1.3 \times 10^{12}$ ohm-cm | |

The results show the film performed well as an antistatic film both in terms of decay time and resistivity, and was resistant to abusive aging.

## EXAMPLE III

By blending with heat using a Berstorff twin screw extruder, a premix of pellets was made. First, 60 parts by weight EVA [LD318.92] and 30 parts by weight EAA [Primacor 5981] were mixed, and then added thereto was 15 parts by wt. QA [Emerstat 6660]. The resultant EVA + EAA + QA was then further blended with more polymer, and hot blown, 5-layer, extruded, tubular film having a thickness of about 4 mil (0.102 mm) was made. The ingredients of each layer were as recited in Table IIIA and are in % by weight.

TABLE IIIA

| OUTSIDE LAYER 1 | INTERIOR LAYER 2 | CORE LAYER 3 | INTERIOR LAYER 4 | OUTSIDE LAYER 5 |
|---|---|---|---|---|
| 95% EVA<br>5% Anti-block | 66-2/3% EVA<br>33-1/3% Mix of EVA + EAA + QA | 90% LLDPE<br>10% Mix of EVA + EAA + QA | 66-2/3% EVA<br>33-1/3% Mix of EVA + EAA + QA | 95% EVA<br>5% Anti-block |

Then, the following electrical measurements were taken on samples of film as reported in Table IIIB.

TABLE IIIB

| Abuse Treatment Noted or Film Tested As is | Ohms/square Surface Resistivity | Ohms-cm Volume Resistivity | Static Decay Time(ms) 1 Hr. Equilibration for the Film as is or after abuse treatment | 24 Hr. Equilibration for the Film as is or after abuse treatment | Tribo Volts |
|---|---|---|---|---|---|
| As is | $1.8x10^{13}$ | $7.0x10^{13}$ | 111 | 222 | -1.2 |
| 1 Hr. Shower | $1.4x10^{14}$ | $2.1x10^{14}$ | 7 | 177 | 181.9 |
| 3 Hr. Shower | $5.7x10^{14}$ | $1.6x10^{14}$ | Less Than MMSDT* | 115 | 161.5 |
| 24 Hr. Shower | $6.4x10^{12}$ | $4.4x10^{14}$ | Less Than MMSDT | 102 | 76.4 |
| 24 Hr. Hot Humid Oven | $1.6x10^{13}$ | $2.5x10^{14}$ | 183 | 328 | 48.6 |
| Hot Dry Oven | | | | | |
| Day 1 | NT** | NT | 332 | 185 | NT |
| Day 2 | NT | NT | 272 | 178 | NT |
| Day 3 | NT | NT | 180 | 164 | NT |
| Day 4 | NT | NT | 287 | Won't Accept Full Charge | NT |
| Day 5 | NT | NT | 148 | 115 | NT |
| Day 6 | NT | NT | 164 | 348 | NT |
| Day 7 | NT | NT | 359 | 200 | NT |

| Abuse Treatment Noted or Film Tested As is | Ohms/square Surface Resistivity | Ohms-cm Volume Resistivity | Static Decay Time(ms) 1 Hr. Equilibration for the Film as is or after abuse treatment | 24 Hr. Equilibration for the Film as is or after abuse treatment | Tribo Volts |
|---|---|---|---|---|---|
| Day 8 | NT | NT | NT | 455 | NT |
| Day 9 | NT | NT | 400 | 97 | NT |
| Day 10 | NT | NT | 213 | 259 | NT |
| Day 11 | NT | NT | 247 | 93 | NT |
| Day 12 | $4.2x10^{13}$ | $1.0x10^{16}$ | 299 | 164 | -19.3 |

*MMSDT = minimum measurable static decay time
**NT = not tested

It is noted from Table IIIB that while the resistivity measurements bordered between antistatic and insulative (i.e. $10^{13}$ to $10^{16}$), the static decay times were excellent, well under the preferred 2000 ms or less, even after the hot oven abuse or the water shower abuse. As for the film sample that would not accept a full charge after day 4 of the hot dry oven, while it is not intended to be bound to any theory, it is believed this happened due to a mechanical difficulty in that the sample was placed in the test meter in a curved or bowed position instead of a flat, taut position, with respect to the sensing electrode. (It is also noted that 2 similar 5-layer films were made, the only difference being that core layer 3 contained only 5% of the premix of EVA + EAA + QA or contained no premix of EVA + EAA + QA. These similar films performed substantially the same, but for not accepting a full charge during the SDT test after 10 to 12 days in a hot dry oven. While it is not intended to be bound to any theory, it is believed this was also due to a mechanical difficulty in that samples were placed in the test meter in a bowed position.)

## EXAMPLE IV

Six tubes of a 5-layer film were made as in Example III, but containing the following amounts of ingredients for each layer as recited in Table IVA below:

TABLE IVA

| Layer 1 | Layer 2 | Layer 3 | Layer 4 | Layer 5 |
|---|---|---|---|---|
| 95% EVA 10% Anti-block | 66-2/3% EVA 33-1/3% Mix of EVA + EAA + QA | 90% LLDPE 10% Mix of EVA + EAA + QA | 66-2/3% EVA 33-1/3% Mix of EVA + EAA + QA | 90% EVA 10% Anti-block |

Samples of the 6 tubes of the 5-layer film were tested for static decay time after 1 hour of equilibration and the results were as reported in Table IVB below:

TABLE IVB

| SAMPLE OF FILM | SDT (ms) |
|---|---|
| Tube 1 | 14 |
| Tube 2 | 43 |
| Tube 3 | 9 |
| Tube 4 | 23 |
| Tube 5 | 31 |
| Tube 6 | 18 |

As can be seen, excellent SDT's were obtained.

Next 3 sets of 4 samples each of the 6 tubes of 5-layer Film were subjected to a 24-hour water shower. Then, each set was equilibrated for 1 hour, 24 hours, and 48 hours, respectively and then checked for SDT. The results were as reported in Table IVC below:

TABLE IVC

| Tube | Sample | SDT (ms) After 1 Hour Equilibration | After 24 Hours Equilibration | After 48 Hours Equilibration |
|---|---|---|---|---|
| 1 | 1 | Less Than MMSDT* | 24 | 29 |
| 1 | 2 | Less Than MMSDT | 23 | 41 |
| 1 | 3 | Less Than MMSDT | 15 | 23 |
| 1 | 4 | Less Than MMSDT | 16 | 24 |
| 2 | 1 | Less Than MMSDT | 60 | 54 |
| 2 | 2 | Less Than MMSDT | 54 | 50 |
| 2 | 3 | Less Than MMSDT | 71 | 66 |
| 2 | 4 | Less Than MMSDT | 70 | 71 |
| 3 | 1 | Less Than MMSDT | 18 | 16 |
| 3 | 2 | Less Than MMSDT | 17 | 20 |
| 3 | 3 | Less Than MMSDT | 13 | 20 |
| 3 | 4 | Less Than MMSDT | 11 | 18 |
| 4 | 1 | Less Than MMSDT | 76 | 78 |
| 4 | 2 | Less Than MMSDT | 38 | 32 |
| 4 | 3 | Less Than MMSDT | 53 | 60 |
| 4 | 4 | Less Than MMSDT | 84 | 85 |
| 5 | 1 | Less Than MMSDT | 69 | 65 |
| 5 | 2 | Less Than MMSDT | 84 | 76 |
| 5 | 3 | Less Than MMSDT | 32 | 30 |
| 5 | 4 | Less Than MMSDT | 33 | 34 |

| Tube | Sample | SDT (ms) After 1 Hour Equilibration | After 24 Hours Equilibration | After 48 Hours Equilibration |
|---|---|---|---|---|
| 6 | 1 | Less Than MMSDT | 106 | 108 |
| 6 | 2 | Less Than MMSDT | 114 | 136 |
| 6 | 3 | Less Than MMSDT | 64 | 92 |
| 6 | 4 | Less Than MMSDT | 152 | 161 |

*MMSDT = Minimum measurable static decay time

As can be seen, when film was left to equilibrate for 24 hours, which is as per the specifications of Federal Test Method 101c, then excellent SDT's were obtained. Also, the film retained excellent SDT's even after further equilibration. Thus, these films indeed survived the vigorous abuse of a 24 hour water shower.

## EXAMPLE V

For polycarbonate compatibility, i.e. crazing tests, also a mono-layer film was extruded from the pellets of premix having the ingredients as recited in Table V-A below:

TABLE V-A

60 parts by wt LLDPE [Dowlex2045.03]

15 parts by wt QA [Q-14-2]

30 parts by wt EAA [Primacor 5981] and then both a sample from Tube 1 of the 5-layer film of Example IV and a sample from the mono-layer film were tested for crazing of polycarbonate. The results are summarized in Table V-B below:

TABLE V-B

| Test Conditions | | | Tube 1 of 5-layer Film | Mono-layer Film |
|---|---|---|---|---|
| Temperature | Pressure | | | |
| 73° F(22.8° C) | PSI | kg/cm² | | |
| | 1000 | 70 | N | N |
| | 1700 | 120 | N | N |
| | 2000 | 141 | N | N |
| | 2500 | 176 | N | N |
| | 3400 | 239 | N | N |
| 120° F(48.9° C) | | | | |
| | 1000 | 70 | N | N |
| | 1700 | 120 | N | N |
| | 2000 | 141 | N | N |
| | 2500 | 176 | N | N |
| | 3400 | 239 | VSLC | N |
| 158° F(70° C) | | | | |
| | 1000 | 70 | N | N |
| | 1700 | 120 | N | N |
| | 2000 | 141 | N | VSLC |
| | 2500 | 176 | N | VSLC |
| | 3400 | 239 | VSLC | VSLC |
| 185° F(85° C) | | | | |
| | 1000 | 70 | N | N |
| | 1700 | 120 | N | N |
| | 2000 | 141 | N | VSLC |
| | 2500 | 176 | VSLC | VSLC |
| | 3400 | 239 | VSLC | SLC |
| N = NO ATTACK<br>VSLC = VERY SLIGHT CRAZE<br>SLC = SLIGHTLY CRAZED | | | | |

As can be seen the 5-layer film D performed excellently and did not exhibit very slight crazing till the most extreme condition of 3400 psi, whereas the mono-layer film only showed very slight crazing beginning at a less extreme condition of 2000 psi.

## EXAMPLE VI

Quaternary amine additives QA1-QA5 (below) were prepared by mixing the following TA's (tertiary amines) and acids or alkylating agents without solvent for the indicated time/temp.

TABLE VIA

| QA | Formula | TA(gms) | Acid or Alkylating Agent(gms) | Time/Temp. |
|---|---|---|---|---|
| QA1 | $H(CH_2)_{12}N(CH_3)_2H^+ CH_3SO_3^-$ | Empigen AB (8.8) | MSA (3.2) | 10 min./60° C |
| QA2 | $H(CH_2)_{12}N(CH_3)_2C_2H_5^+ C_2H_5OSO_3^-$ | Empigen AB (8.8) | DES (5.2) | 16hr./60° C |
| QA3 | $H(CH_2)_{10-18}(OC_2H_4)_{1-5}N(CH_3)_2H^+ CH_3SO_3^-$ | Empigen AY (14.4) | MSA (3.2) | 10 min./60° C |
| QA4 | $C_{10}H_{21}OC_3H_6N(C_2H_4OH)_2H^+ CH_3SO_3^-$ | E14-2 (12.4) | MSA (3.2) | 10 min./60° C |
| QA5 | $C_{10}H_{21}OC_3H_6N(C_2H_4OH)_2H^+ H(CH_2)_{12-18}C_6H_4SO_3^-$ | E14-2 (12.4) | DBSA (10.0) | 10 min./60° C |

Several quaternary amines (QA, 3.6 parts by weight) were blended with Primacor 5981 ethylene-acrylic acid copolymer (7.1 parts by weight) and LD318.92 ethylene-vinyl acetate copolymer (89.3 parts by weight). The blending was carried out by kneading at 130-150° C for approximately 20 minutes in a Brabender Plasticorder® mixer. Samples of the resultant materials were pressed at approximately 1,000 psi (70 kg/cm) between platens heated to 150° C. Monolayer films of about 3 inches (7.6 cm) by 5 inches (12.7 cm) by 0.005 inch (0.013 cm) were thus obtained. The SDT of each film was determined before and after a 24-hour water shower. The results are summarized below:

TABLE VIB

| Sample | QA | SDT Before Shower (ms) | SDT After Shower (ms) |
|---|---|---|---|
| 1 | QA5 | 490 | 2450 |
| 2 | QA4 | 40 | 1000 |
| 3 | QA1 | 90 | 510 |
| 4 | QA2 | 100 | 880 |

These results demonstrate that the performance of the films tested was slightly degraded by an extensive water shower, but still less than 3000 ms for Sample 1 and less than the preferred 2000 ms for Samples 2, 3, and 4.

Next, several quaternary amines (QA 5.0 parts by weight) were blended with Primacor 1410 ethylene-acrylic acid copolymer (71.3 parts by weight) and LD318.92 ethylene-vinyl acetate copolymer (23.7 parts by weight). The blending and subsequent film preparation and testing were carried out as described above for the samples reported in Table VIB. The results were as follows:

TABLE VIC

| Sample | QA | SDT Before Shower (ms) | SDT After Shower (ms) |
|---|---|---|---|
| 5 | Cyastat LS | 420 | 500 |
| 6 | Larostat 264A | 590 | 630 |
| 7 | QA3 | 110 | 650 |
| 8 | QA1 | 550 | 720 |
| 9 | QA2 | 70 | 180 |

These results demonstrate that there was almost no loss of static decay performance after extensive water washing, and all SDT's were less than the preferred 2000 ms.

To demonstrate further permanence of these materials, the same samples 5 through 9 from after the water shower were further aged for 12 days in an oven at 70° C and ambient humidity, i.e. a "dry" oven as there was no water beaker. SDT, surface resistivity, and volume resistivity for the resulting films are given below:

TABLE VID

| RESULTS AFTER WATER SHOWER AND 12-DAY AGING AT 70 °C | | | |
|---|---|---|---|
| Sample | SDT (ms) | Surface Resistivity (ohms/square) | Volume Resistivity (ohm-cm) |
| 5 | 1660 | $1.1x10^{13}$ | $4.4x10^{12}$ |
| 6 | 1790 | $4.0x10^{12}$ | $1.3x10^{12}$ |
| 7 | 330 | $3.8x10^{11}$ | $7.7x10^{11}$ |
| 8 | 790 | $4.7x10^{11}$ | $9.1x10^{11}$ |
| 9 | 120 | $3.8x10^{11}$ | $1.1x10^{11}$ |

The results demonstrate that films produced with 5% of a QA additive in an EAA/EVA resin show excellent static decay times, surface resistivities, and volume resistivities, and are highly permanent, i.e., insensitive to water washout of additive and 12-day aging at elevated temperature.

## Comparative Example VII

A comparative sample was run for comparison with Sample 5 as reported in Tables VIC and VID above to show the result of omitting the ethylene-acrylic acid copolymer from the formulation. Thus, Cyastat LS (5.0 parts by weight) and LD318.92 ethylene-vinyl acetate copolymer (95.0 parts by weight) were kneaded at 130-150 °C in a Brabender Plasticorder® mixer. Effective mixing of these ingredients was never obtained, even after 4 hours of kneading. Reduction of the additive content to 2.5 parts by weight did not solve the problem. This demonstrates that an acid copolymer containing carboxylic acid moieties (i.e. the ethylene-acrylic acid copolymer) plays a critical role in compatibilizing the polyolefin with the ionic additive.

Another comparative sample was run but this time for comparison with Sample 9 as reported in Tables VIC and VID above to show the result of omitting the ethylene-acrylic acid copolymer from the formulation. Thus, QA2 (1.5 parts by weight) and LD318.92 ethylene-vinyl acetate copolymer (98.5 parts by weight) were kneaded at 130-150 °C in a Brabender Plasticorder® mixer. Effective mixing of these ingredients was obtained, finally after 4 hours of kneading. Some of the resultant material was pressed at approximately 1000 psi (70 kg/cm$^2$) between platens heated to 150 °C. Mono-layer film of about 3 X 5 X 0.005 inches (7.6 X 12.7 X 0.013 cm) was thus obtained. The SDT of each film was determined before and after a 24-hour water shower. The results are summarized below:

TABLE VII

| SDT Before Shower (ms) | SDT After Shower (ms) |
|---|---|
| 580 | over 30000 |

Also, after the water shower, the film held a charge of 10 kilovolts, which indicates the antistatic property was lost. This demonstrates that an acid copolymer containing carboxylic acid moieties (i.e. the ethylene-acrylic acid copolymer) plays a critical role in providing permanent antistatic characteristics, i.e. enabling the film still to have a SDT less than about 3000 ms, more preferably less than about 2000 ms, <u>after</u> a 24-hour water shower.

## EXAMPLE VIII

Quaternary amine QA2 (as defined in Table VIA, 6.0 parts) was blended with Surlyn 1650 partially zinc neutralized ethylene-methacrylic acid-zinc methacrylate ionomer (23.5 parts) and LD318.92 ethylene-vinyl acetate copolymer (70.5 parts). The blending and subsequent testing were carried out as described in Example VI. The results were as follows:

| Before Water Shower: | |
|---|---|
| SDT (ms) | 470 |
| Surface Resistivity (ohms/square) | $1.7 \times 10^{12}$ |
| Volume Resistivity (ohm-cm) | $2.5 \times 10^{12}$ |

| After 24-Hour Water Shower: | |
|---|---|
| SDT (ms) | 880 |
| Surface Resistivity (ohms/square) | $7.6 \times 10^{12}$ |
| Volume Resistivity (ohm-cm) | $3.6 \times 10^{10}$ |

| After 24-Hour Water Shower Followed by 12-Day/70°C Aging: | |
|---|---|
| SDT (ms) | 460 |
| Surface Resistivity (ohms/square) | $1.7 \times 10^{12}$ |
| Volume Resistivity (ohm-cm) | $2.5 \times 10^{12}$ |

These results demonstrate that the film showed excellent static decay time, surface and volume resistivity, and resistance to water washout of additive and aging at elevated temperature.

## EXAMPLE IX

Quaternary amine QA1 (5.0 parts) was blended with Surlyn 1650 partially zinc neutralized ethylene-methacrylic acid-zinc methacrylate ionomer (23.7 parts) and LD318.92 ethylene-vinyl acetate copolymer (71.3 parts). The blending and subsequent testing were carried out as described in Example VI. The results were as follows:

| Before Water Shower: | |
|---|---|
| SDT (ms) | 230 |
| Surface Resistivity (ohms/square) | $5.2 \times 10^{11}$ |
| Volume Resistivity (ohm-cm) | $1.4 \times 10^{12}$ |

| After 24-Hour Water Shower: | |
|---|---|
| SDT (ms) | 150 |
| Surface Resistivity (ohms/square) | $6.5 \times 10^{11}$ |
| Volume Resistivity (ohm-cm) | $1.1 \times 10^{12}$ |

| After 24-Hour Water Shower Followed by 12-Day/70 °C Aging: | |
|---|---|
| SDT (ms) | 80 |
| Surface Resistivity (ohms/square) | $5.9 \times 10^{11}$ |
| Volume Resistivity (ohm-cm) | $5.9 \times 10^{12}$ |

These results demonstrate that the film showed excellent static decay time, surface and volume resistivity, and resistance to water washout of additive and aging at elevated temperature.

## EXAMPLE X

Quaternary amine QA6, N,N-dimethyl-N-ethyl-N-cocoammonium ethosulfate, was prepared as follows: 9.36 g of N,N-dimethylcocoamine was combined with 6.10 g of diethyl sulfate. After mixing at 80 °C for 2-3 minutes, a clear liquid was formed in an exothermic process. On cooling, a waxy solid (m.p. 65-75 °C) resulted (QA6).

Quaternary amine QA6 (4.44 g) was blended with 10 g Dow Primacor 1410 (ethylene-acrylic acid copolymer, 9% AA, 1.5 melt index) and 30 g Exxon LD318.92 (ethylene-vinyl acetate copolymer, 9% VA, 2.0 melt index). Blending was carried out in a Brabender Plasticorder mixer at 130 °C for 30 minutes. A sample of the resultant material was pressed at approximately 1,000 psi (70 kg/cm$^2$) between platens heated to 150 °C. A monolayer film of about 3 inches (7.6 cm) by 5 inches (12.7 cm) by 0.005 inch (0.013 cm) was thus obtained.

The surface resistivity of the sample was tested by two methods: First, the sample was equilibrated at 12.5 ±0.5% RH for 48 hours and tested with a Keithley 6105 resistivity adapter (Keithley Instruments, Cleveland, Ohio) connected to a Keithley 247 high voltage supply and a Keithley 485 picoammeter. With an applied voltage of 100 volts, a surface resistivity of $9.96 \times 10^9$ ohms/square was obtained. Second, the sample was equilibrated at 35 ±5% RH for > 2 hours and tested with a TREK model 150 resistivity meter (TREK, Inc., Medina, NY). A surface resistivity of $9 \times 10^7$ ohms/square was obtained.

## EXAMPLE XI

Quaternary amine QA6 (4.44 g) was blended with 10 g Surlyn 1650 partially zinc neutralized ethylene-methacrylic acid-zinc methacrylate terpolymer and 30 g Exxon LD318.92 as described in Example X.

When prepared and tested as described in Example X, a film sample of this material gave the following results:

Surface Resistivity after equilibration at 12.5 ± 0.5% RH for 48 hrs.: $2.00 \times 10^{10}$ ohms/square
Surface Resistivity after equilibration at 35 ± 5% RH $\frac{1}{2}$ 2 hrs.: $2 \times 10^8$ ohms/square

## EXAMPLE XII

By blending with heat using a Berstorff twin screw extruder, a premix of pellets was made. First, 60 parts by weight EVA (LD318.92) and 30 parts by weight EAA (Primacor 5981) were mixed, and then added thereto was parts by wt. QA [Emerstat 6660]. The resultant EVA + EAA + QA was then further blended with more polymer, and hot blown, 5-layer, extruded, tubular film having a thickness of about 4 mil (0.102 mm) was made. The ingredients of each layer were as recited in Table XIIA and are in % by weight.

TABLE XIIA

| OUTSIDE LAYER 1 | INTERIOR LAYER 2 | CORE LAYER 3 | INTERIOR LAYER 4 | OUTSIDE LAYER 5 |
|---|---|---|---|---|
| 100% EVA | 100% EVA | 100% LLDPE | 100% EVA | 66-2/3% EVA<br>33-1/3% Mix of EVA + EAA + QA |

Then, the following electrical measurements were taken on samples of film as reported in Table XIIB. Resistivity was measured at about 12.5 ±2.5% RH using a Keithley picoammeter with a separate 100 volt power source and an Electro Technical Services cell conforming to ASTM D257.

TABLE XIIB

| | | | Static Decay Time (ms) | | | |
|---|---|---|---|---|---|---|
| Abuse Treatment or Film Tested As is | Ohms/square Surface Resistivity | Ohms-cm Volume Resistivity | 1 Hr. Equilibration treatment | 24 Hr. Equilibration treatment | 48 Hr. Equilibration treatment | Tribo Volts |
| As is | $5.9 \times 10^{11}$ | $1.8 \times 10^{16}$ | 1852 | 1824 | NT* | 86 |
| 24 Hr. Shower | $1.9 \times 10^{14}$ | NT | NT | WON'T ACCEPT FULL CHARGE | WON'T ACCEPT FULL CHARGE | NT |
| Hot Dry Oven | | | | | | |
| Day 1 | NT | NT | 2190 | 1722 | NT | NT |
| Day 2 | NT | NT | 1492 | 3000 | NT | NT |
| Day 3 | NT | NT | 1471 | 1398 | NT | NT |
| Day 4 | NT | NT | 1326 | 1332 | NT | NT |
| Day 5 | NT | NT | 1501 | 1453 | NT | NT |
| Day 6 | NT | NT | NT | NT | NT | NT |
| Day 7 | NT | NT | NT | NT | NT | NT |
| Day 8 | NT | NT | NT | NT | NT | NT |
| Day 9 | NT | NT | NT | NT | NT | NT |
| Day 10 | NT | NT | NT | 1845 | NT | NT |
| Day 11 | NT | NT | NT | 1794 | NT | NT |
| Day 12 | $2.0 \times 10^{12}$ | $2.3 \times 10^{16}$ | NT | 15940 | NT | 537 |

*NT = not tested

These results illustrate that after 11 days in a hot oven, the film exhibited an excellent SDT less than 2000 ms.

## EXAMPLE XIII

By blending with heat using a Berstorff twin screw extruder, a premix of pellets was made. First, 60 parts by weight EVA [LD318.92] and 30 parts by weight EAA [Primacor 5981] were mixed. and then added thereto was 20 parts by wt. QA [Emerstat 6660]. The resultant mix of EVA + EAA + QA was then further blended with more.polymer, and hot blown, 5-layer extruded, tubular film having a thickness of about 4 mil (0.102 mm) was made. The ingredients of each layer were as recited in Table XIIIA and are in % by weight.

Table XIIIA

| OUTSIDE LAYER 1 | INTERIOR LAYER 2 | CORE LAYER 3 | INTERIOR LAYER 4 | OUTSIDE LAYER 5 |
|---|---|---|---|---|
| 66-2/3% Primacor 1410<br>33-1/3% Mix of EVA+EAA+QA | 66-2/3% EVA<br>33-1/3% Mix of EVA+EAA+QA | 100% LLDPE | 66-2/3% EVA<br>33-1/3% Mix of EVA+EAA+QA | 66-2/3% Primacor 1410<br>33-1/3% Mix of EVA+EAA+QA |

Then, the following electrical measurements were taken on samples of film as reported in Table XIIIB. Resistivity was measured at about 12.5 ±2.5% RH using a Keithley picoammeter with a separate 100 volt power source and an Electro Technical Services cell conforming to ASTM D257.

TABLE XIIIB

| | | | Static Decay Time (ms) | | | |
|---|---|---|---|---|---|---|
| Abuse Treatment or Film Tested As is | Ohms/square Surface Resistivity | Ohms-cm Volume Resistivity | 1 Hr. Equilibration treatment | 24 Hr. Equilibration treatment | 48 Hr. Equilibration treatment | Tribo Volts |
| As is | $1.3 \times 10^{11}$ | $5.1 \times 10^{13}$ | 40 | 80 | NT* | 47 |
| 24 Hr. Shower | $7.9 \times 10^{11}$ | NT | NT | 109 | 108 | NT |
| Hot Dry Oven | | | | | | |
| Day 1 | NT | NT | 217 | 185 | NT | NT |
| Day 2 | NT | NT | 130 | 181 | NT | NT |
| Day 3 | NT | NT | 68 | 64 | NT | NT |
| Day 4 | NT | NT | 73 | 84 | NT | NT |
| Day 5 | NT | NT | 86 | 88 | NT | NT |
| Day 6 | NT | NT | 107 | NT | NT | NT |
| Day 7 | NT | NT | NT | NT | NT | NT |
| Day 8 | NT | NT | NT | NT | NT | NT |
| Day 9 | NT | NT | NT | NT | NT | NT |
| Day 10 | NT | NT | NT | 84 | NT | NT |
| Day 11 | NT | NT | NT | 94 | NT | NT |
| Day 12 | $1.6 \times 10^{11}$ | $2.1 \times 10^{13}$ | NT | 51 | NT | 56 |

*NT = not tested

These results illustrate that after a 24-hour water shower and also after 12 days in a hot oven, the film

exhibited both a permanent antistatic SDT less than 2000 ms and a permanent surface resistivity in the antistatic surface resistivity range of $10^5$ to $10^{12}$ ohms/square.

## EXAMPLE XIV

By blending with heat using a Berstorff twin screw extruder, a premix of pellets was made. First, 60 parts by weight EVA [LD318.92] and 30 parts by weight EAA [primacor 5981] were mixed, and then added thereto was 20 parts by wt. QA [Emerstat 6660]. The resultant mix of EVA + EAA + QA was then further blended with more polymer, and hot blown, 5-layer, extruded, tubular film having a thickness of about 4 mil (0.102 mm) was made. The ingredients of each layer were as recited in Table XIVA and are in % by weight.

Table XIVA

| OUTSIDE LAYER 1 | INTERIOR LAYER 2 | CORE LAYER 3 | INTERIOR LAYER 4 | OUTSIDE LAYER 5 |
|---|---|---|---|---|
| 56-2/3% Primacor 1410<br>33-1/3% Mix of EVA + EAA + QA 10% Antiblock | 66-2/3% EVA<br>33-1/3% Mix of EVA + EAA + QA | 100% LLDPE | 66-2/3% EVA<br>33-1/3% Mix of EVA + EAA + QA | 56-2/3% Primacor 1410<br>33-1/3% Mix of EVA + EAA + QA 10 % Antiblock |

Then, the following electrical measurements were taken on samples of film as reported in Table XIVB. Resistivity was measured at about 12.5 ± 2.5% RH using a Keithley picoammeter with a separate 100 volt power source and an Electro Technical Services cell conforming to ASTM D257.

TABLE XIVB

| | | | Static Decay Time (ms) | | | |
|---|---|---|---|---|---|---|
| Abuse Treatment or Film Tested Tribo As is | Ohms/square Surface Resistivity | Ohms-cm Volume Resistivity | 1 Hr. Equilibration treatment | 24 Hr. Equilibration treatment | 48 Hr. Equilibration treatment | Volts |
| As is | $1.2 \times 10^{11}$ | $5.8 \times 10^{13}$ | 11 | 31 | NT* | 35 |
| 24 Hr. Shower | $6.6 \times 10^{11}$ | NT | NT | 70 | 62 | NT |
| Hot Dry Oven | | | | | | |
| Day 1 | NT | NT | 40 | 26 | NT | NT |
| Day 2 | NT | NT | 42 | 32 | NT | NT |
| Day 3 | NT | NT | 41 | 40 | NT | NT |
| Day 4 | NT | NT | 36 | 33 | NT | NT |
| Day 5 | NT | NT | 52 | 42 | NT | NT |
| Day 6 | NT | NT | 53 | NT | NT | NT |
| Day 7 | NT | NT | NT | NT | NT | NT |
| Day 8 | NT | NT | NT | NT | NT | NT |
| Day 9 | NT | NT | NT | NT | NT | NT |
| Day 10 | NT | NT | NT | 45 | NT | NT |
| Day 11 | NT | NT | NT | 44 | NT | NT |
| Day 12 | $1.6 \times 10^{11}$ | $2.4 \times 10^{13}$ | NT | 65 | NT | 35 |

*NT = not tested

These results illustrate that after a 24-hour water shower and also after 12 days in a hot oven, the film

exhibited both a permanent antistatic SDT less than 2000 ms and a permanent surface resistivity in the antistatic surface resistivity range of $10^5$ to $10^{12}$ ohms/square.

## EXAMPLE XV

A thin rigid polyethylene terephthalate (PET) sheet is made by using conventional techniques. The sheet is dielectric and holds a charge sof 1000 volts for over 5 seconds. Using a conventional laminator, the 5-layer flexible antistatic film of Example XIII is laminated to both surfaces of the PET sheet. The resultant is vacuum thermoformed into clam shell type containers, which, when folded over and sealed, would envelope, for instance, a circuit board. The resultant rigid laminate container is of dimensions suitable for containing printed circuit boards or similar static sensitive devices. It should be permanently antistatic. It should dissipate 5000 Vdc in less than 3000 ms after a 24 hour water shower. It should also have permanent antistatic resistivity and exhibit a surface resistivity of about $10^{11}$ ohms/square after a 24 hour water shower.

## EXAMPLE XVI

The procedure of Example XV is repeated except this time the flexible 5-layer antistatic film of Example XIV is laminated to the PET sheet. The resultant is thermoformed into trays and lids. A circuit board is placed in the tray, and the lid is heat sealed thereto, so that the tray and lid form a container enveloping the circuit board. The resultant rigid laminate container is of dimensions suitable for containing printed circuit boards or similar static sensitive devices. It should be permanently antistatic. It should dissipate 5000 Vdc in less than 3000 ms after a 24 hour water shower. It should also have permanent antistatic resistivity and exhibit a surface resistivity of about $10^{11}$ ohms/square after a 24 hour water shower.

## EXAMPLE XVII

The procedure of Example XV is repeated except this time the rigid sheet is of the multi-layer structure: LLDPE/adhesive/EVOH/adhesive/LLDPE.

## EXAMPLE XVIII

The procedure of Example XVII is repeated except this time the flexible 5-layer antistatic film of Example XIV is laminated to the rigid LLDPE/adhesive/EVOH/adhesive/LLDPE sheet. The resultant rigid laminate container is of dimensions suitable for containing printed circuit boards or similar static sensitive devices. It should be permanently antistatic. It should dissipate 5000 Vdc in less than 3000 ms after a 24 hour water shower. It should also have permanent antistatic resistivity and exhibit a surface resistivity of about $10^{11}$ ohms/square after a 24 hour water shower.

It is noted that in addition to being rigid antistatic containers, the containers of Examples XV through XVIII are barrier containers.

From the foregoing description, one skilled in the art can easily ascertain the essential characteristics of this invention, and without departing from the spirit and scope thereof, can make various changes and modifications of the invention to adapt it to various usages and conditions.

## Claims

1. An antistatic rigid container comprising a laminate of a thermoplastic rigid sheet and an antistatic flexible film.

2. The container of claim 1 wherein the sheet is provided by a dielectric material which holds a charge

of 1000 or more volts for more than 5 seconds.

3. The container of claim 1 wherein the film is provided by an antistatic material which exhibits a static decay time of about 3000 milliseconds or less when tested at about room temperature at about 15% or less relative humidity.

4. The container of claim 1 wherein the sheet is formed from sheet material selected from polyethylene terephthalate, polyvinylchloride, nylon, acrylonitrile, poly-propylene, polyester, fluorohalocarbon, polyurethane, ethylene vinyl alcohol, saran, polvinylchloride/polyolefin, polyvinylchloride/saran, polyvinylchloride/saran/polyolefin, polyvinylchloride/saran/ethylene vinylacetate copolymer, polystyrene/saran/polyolefin, polystyrene/saran copolymer, nylon/saran/polyolefin, polyolefin/saran/polyethylene, polyester/saran/polyolefin, polycarbonate/saran/polyolefin, or polyolefin/adhesive/ethylene vinyl alcohol/adhesive/polyolefin.

5. The container of claim 1 wherein the film is formed from a composition of an acid copolymer/quaternary amine mixture wherein the acid copolymer is a copolymer of (i) a major amount by mol % of an alpha-olefin of the formula $RCH=CH_2$ wherein R is H or $C_1$ to $C_{20}$ alkyl, and (ii) a minor amount by mol % of an alpha,beta-ethylenically unsaturated carboxylic acid, and the quaternary amine is of the formula $[(R^1)(R^2)(R^3)(R^4)N]^+ [X]^-$ wherein $R^1$ is selected from H, aryl, or $C_1$ to $C_{50}$ alkyl optionally having one or more non-contiguous C=O or NHC=O or -S- or -O- in the carbon chain, or the same as $R^2$; each of $R^2$, $R^3$, and $R^4$ is the same or different and selected from H, from $C_1$ to $C_{18}$ alkyl optionally substituted with one or more OH, or from $-(R^5-O)_a-H$ where a is an integer from 1 to 10 and $R^5$ is ethylene or propylene; and X is an anion selected from chloride, bromide, iodide, fluoride, nitrate, fluoborate, phosphate, $C_1$ to $C_{20}$ alkyl phosphate, sulfate, $C_1$ to $C_{20}$ alkyl sulfate, formate, $C_1$ to $C_{20}$ alkyl or $C_6$ to $C_{24}$ alkaryl or aryl sulfonate, acetate, citrate, trifluoroacetate, prospionate, tartrate or carbonate.

6. A method of making an antistatic rigid container from a dielectric rigid sheet, said container being suitable for protecting static sensitive devices, comprising forming a container from a rigid dielectric sheet having an antistatic flexible film adhered to it.

7. The method of claim 6 wherein the sheet is provided by a dielectric material which holds a charge of 1000 or more volts for more than 5 seconds.

8. The method of claim 6 wherein the film is provided by an antistatic material which exhibits a static decay time of about 3000 milliseconds or less when tested at about room temperature at about 15% or less relative humidity.

9. The method of claim 6 wherein the rigid sheet is formed from sheet material selected from polyethylene terephthalate, polyvinylchloride, nylon, acrylonitrile, poly-propylene, polyester, fluorohalocarbon, polyurethane, ethylene vinyl alcohol, polvinylchloride/polyolefin, polyvinylchloride/saran, polyvinylchloride/saran/polyolefin, polyvinylchloride/saran/ethylene vinylacetate copolymer, polystyrene/saran/polyolefin, polystyrene/saran copolymer, nylon/saran/polyolefin, polyolefin/saran/polyethylene, polyester/saran/polyolefin, polycarbonate/saran/polyolefin, or polyolefin/adhesive/ethylene vinyl alcohol/adhesive/polyolefin.

10. The method of claim 6 wherein the antistatic film is formed from a composition of an acid copolymer/quaternary amine mixture wherein the acid copolymer is a copolymer of (i) a major amount by mol % of an alphaolefin of the formula $RCH=CH_2$ wherein R is H or $C_1$ to $C_{20}$ alkyl, and (ii) a minor amount by mol % of an alpha,beta-ethylenically unsaturated carboxylic acid, arid the quaternary amine is of the formula $[(R^1)(R^2)(R^3)(R^4)N]^+ [X]^-$ wherein $R^1$ is selected from H, aryl, or $C_1$ to $C_{50}$ alkyl optionally having one or more non-contiguous C=O or NHC=O or -S-or -O- in the carbon chain, or the same as $R^2$; each of $R^2$, $R^3$, and $R^4$ is the same or different and selected from H, from $C_1$ to $C_{18}$ alkyl optionally substituted with one or more OH, or from $-(R^5-O)_a-H$ where a is an integer from 1 to 10 and $R^5$ is ethylene or propylene; and X is an anion selected from chloride, bromide, iodide, fluoride, nitrate,fluoborate, phosphate, $C_1$ to $C_{20}$ alkyl phosphate, sulfate, $C_1$ to $C_{20}$ alkyl sulfate, formate, $C_1$ to $C_{20}$ alkyl or $C_6$ to $C_{24}$ alkaryl or aryl sulfonate, acetate, citrate, triflouroacetate, propionate, tartrate or carbonate.

11. A package comprising a static sensitive device enveloped within a rigid antistatic container of a laminate of a rigid dielectric sheet and an antistatic flexible film.

12. A antistatic rigid container comprising a laminate of a thermoplastic rigid sheet selected from polyethylene terephthalate, polyolefin, ethylene vinyl alcohol, or combinations thereof, and an antistatic flexible film which is a blend of acid copolymer and quaternary amine, wherein said container will, after 12 days of abuse in a hot oven at about 71 °C, dissipate 5000 volts direct current when tested at room temperature at 15% relative humidity or less.

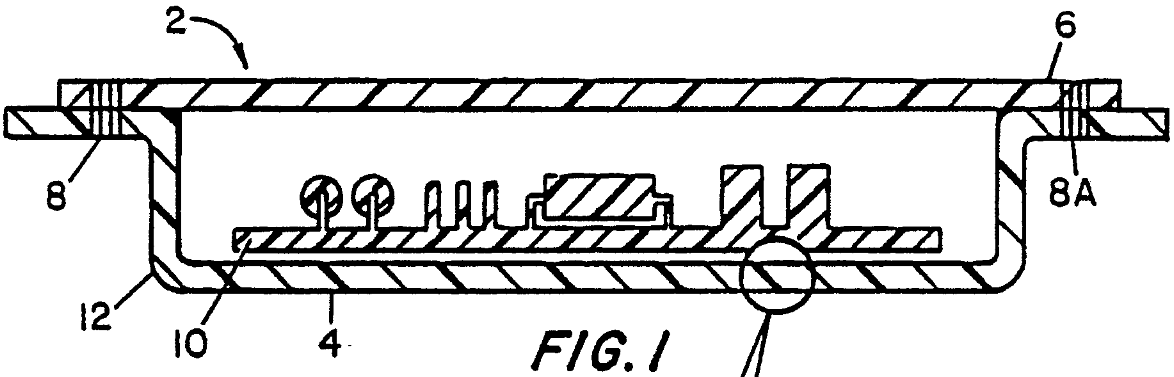


FIG. 1

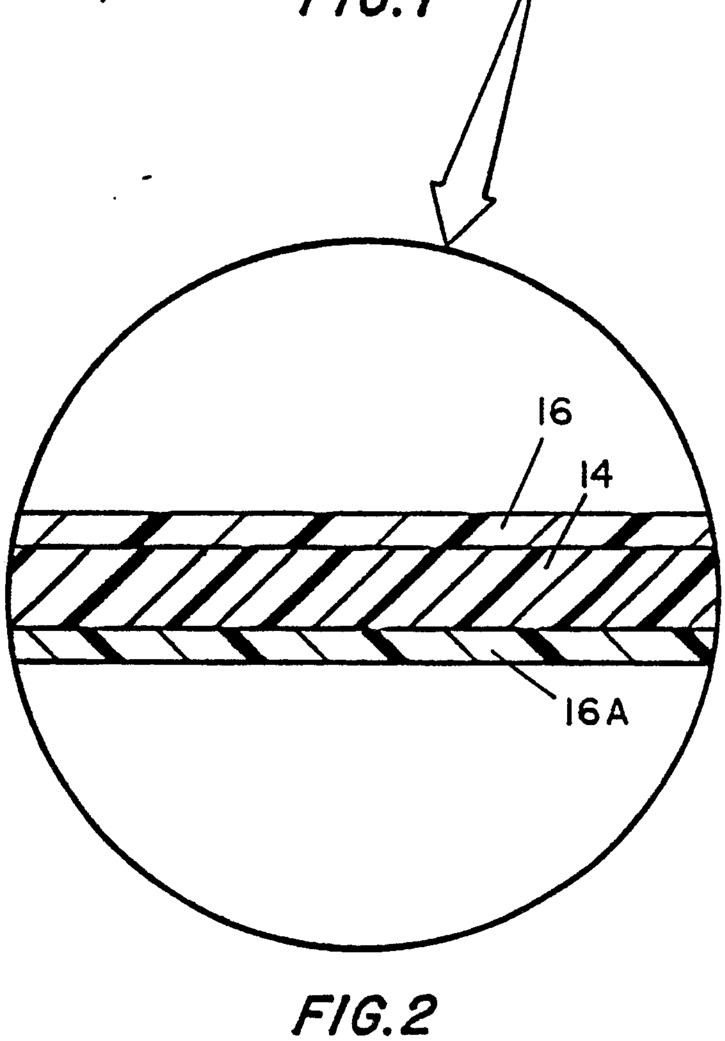


FIG. 2

European Patent Office

# EUROPEAN SEARCH REPORT

Application Number

EP 90 10 8873

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| X | GB-A-2028168 (IMPERIAL CHEMICAL IND)<br>* page 1, lines 5 - 35 *<br>* page 2, lines 15 - 45 *<br>* page 4, lines 6 - 11 *<br>* page 6, lines 26 - 29 * | 1-4, 6-9, 11 | B32B1/02<br>B32B27/00<br>B32B27/18<br>C08K5/19<br>C08K5/17<br>C09K3/16<br>C09J123/08<br>B65D90/46 |
| Y | | 5, 10, 12 | |
| X | GB-A-938729 (IMPERIAL CHEMICAL IND))<br>* page 1, lines 42 - 63 *<br>* page 2, lines 5 - 6 *<br>* page 2, lines 26 - 78 *<br>* page 3, lines 21 - 61 * | 1-4, 6-9, 11 | |
| A | | 5, 10, 12 | |
| Y | US-A-4623589 (SIMMONDS, JR.)<br>* column 2, line 64 - column 3, line 31 *<br>* column 3, lines 48 - 60 *<br>* column 7, lines 14 - 47 * | 5, 10, 12 | |
| A,D | US-A-4623564 (LONG ET AL.)<br>* the whole document * | 1 | TECHNICAL FIELDS SEARCHED (Int. Cl.5 ) |
| A | US-A-4599366 (KESLING, JR. ET AL.)<br>* column 1, lines 5 - 10 *<br>* column 2, lines 4 - 50 *<br>* column 3, lines 50 - 64 * | 5 | B32B<br>C08K5<br>C09J123<br>C09K3<br>H05F3 |
| A | FR-A-2407942 (MITSUI PETROCHEMICAL IND.)<br>* page 2, line 7 - page 3, line 13 * | 5 | |

The present search report has been drawn up for all claims

| Place of search | Date of completion of the search | Examiner |
|---|---|---|
| THE HAGUE | 28 AUGUST 1990 | IBARROLA TORRES O. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document



EPO FORM 1503 03.82 (P0401)